# EUROPEAN PATENT APPLICATION

(11) **EP 2 204 475 A2**
(43) Date of publication of application: **07.07.2010**
(21) Application number: 09169815.9
(22) Date of filing: 09.09.2009
(51) Int. Cl.: C30B 11/00

(54) **Unidirectional-solidification process and castings formed thereby**

(30) Priority: 25.09.2008 US 237562
(71) Applicant: General Electric Company, Schenectady, NY 12345 (US)
(72) Inventor: Schaeffer, Jon Conrad, Greenville, SC 29602 (US); Balsone, Stephen Joseph, Greenville, SC 29615 (US); Elliott, Andrew John, Greenville, SC 29615 (US)
(74) Representative: Szary, Anne Catherine

(57) **Abstract**

A process capable of producing large metallic castings (10,32) having lengths of one hundred centimeters or more and a unidirectional crystal structure substantially free of freckle defects. The process includes pouring a molten metal alloy into a preheated mold (20) within a heating zone (26), withdrawing the mold (20) from the heating zone (26), through a heat shield (44), and into a cooling zone (42) to directionally solidify the molten metal alloy, and then cooling the mold (20) to produce the casting (10,32) and the unidirectional crystal structure thereof. The heat shield (44) operates as a barrier to thermal radiation between the heating zone (26) and the cooling zone (42), and the mold (20) is withdrawn at a rate that, in combination with the heat shield (44), maintains a thermal gradient to solidify the molten metal alloy and form primary dendrite arms having an average spacing therebetween of about 150 to about 500 micrometers.

## Description

### BACKGROUND OF THE INVENTION

The present invention generally relates to materials and processes for producing directionally-solidified castings, and particularly to reducing defects in alloys cast as single-crystal (SX) and directionally-solidified (DS) articles suitable for use as components of gas turbines and other high temperature applications.

Components of gas turbines, such as blades (buckets), vanes (nozzles) and combustor components, are typically formed of nickel, cobalt or iron-base superalloys characterized by desirable mechanical properties at turbine operating temperatures. Because the efficiency of a gas turbine is dependent on its operating temperatures, there is a demand for components, and particularly turbine buckets, nozzles, combustor components, and other hot gas path components, that are capable of withstanding higher temperatures. As the material requirements for gas turbine components have increased, various processing methods and alloying constituents have been used to enhance the mechanical, physical and environmental properties of components formed from superalloys. For example, buckets, nozzles and other components employed in demanding applications are often cast by directional casting techniques to have DS or SX microstructures, characterized by a crystal orientation or growth direction in a selected direction to produce columnar polycrystalline or single-crystal articles.

As known in the art, directional casting techniques for producing SX and DS castings generally entail pouring a melt of the desired alloy into an investment mold held at a temperature above the liquidus temperature of the alloy. One such process employs a Bridgman-type furnace to create a heated zone surrounding the mold, and a chill plate at the base of the mold. Solidification of the molten alloy within the mold occurs by gradually withdrawing the mold from the heated zone and into a cooling zone, where cooling occurs by convection and/or radiation.

Solidification initiates at the base of the mold and the solidification front progresses to the top of the mold. Solidification is initiated and controlled within the mold base in a manner that obtains the desired microstructure for the casting. A high thermal gradient is required at the solidification front to prevent nucleation of new grains during directional solidification processes.

As known in the art, dendrites are tree-like structures that form during the solidification of a molten metal. The spacing between dendrite arms in a casting is influenced by the solidification conditions of the casting, with dendrite arm spacing varying inversely with cooling rate. As used herein, primary dendrite arm spacing will be used to denote the average spacing between cores of adjacent dendrites in a casting, measured by sectioning the casting in a direction normal to the crystal growth direction, counting the number of primary arms over the cross-sectional area, and calculating an average spacing (typically by assuming a square array). Secondary dendrite arm spacing can be measured by averaging the spacing between adjacent secondary dendrite arms observed in a section taken parallel to the crystal growth direction. Dendrites that form during the solidification of SX and DS castings can be distinguished from the surrounding material by differences in concentration of certain alloy constituents.

Mechanical properties of DS and SX articles depend in part on the avoidance of high-angle grain boundaries, equiaxed grains, and defects resulting from chemical or elemental interdendritic segregation during the directional solidification process. As an example, depending on the particular chemistry of the superalloy, interdendritic segregation can result in inhomogeneities such as embedded particles and elemental microconstituents of the alloy chemistry that accumulate in interdendritic regions and tend to reduce the strength of the casting. The size of the embedded particles and pools of microconstituents can be significantly reduced by a reduction in primary dendrite arm spacing in the cast article. Interdendritic segregation can also result in the formation of surface freckles, which form during solidification as chains of very small equiaxed grains. Freckles can reduce fatigue life and act as grain initiators during the solidification process that cause unacceptable off-axial grains. Traditional approaches used to minimize the presence or effect of dendritic segregation have included post-casting treatments, such as solid state diffusion heat treatments or mechanical working. However, these techniques are not feasible for addressing dendritic segregation in gas turbine components and other castings that are very large or formed with complex compositions.

The tendency for freckling has been shown to be dependent on composition, an example being the level of tantalum and/or carbon in an alloy. Consequently, freckling has been addressed through careful control or modifications of superalloy compositions, as reported in commonly-assigned U.S. Patent Nos. 5,151,249, 6,091,141 and 6,909,988. Recently, casting process parameters such as withdraw rate, cooling speed, and the solid-liquid interface position have also been shown to have an effect on freckle formation. Commonly-assigned U.S. Patent No. 6,217,286 to Huang et al. discloses a high-gradient casting process that reduces freckling in castings having lengths of up to forty inches (about one hundred centimeters). Huang et al. teach that a high thermal gradient at the solidification front can be achieved with a baffle placed between the mold and cooling zone, for example, a liquid bath or impingement with an inert gas, to achieve a sufficiently uniform primary dendrite arm spacing and reduce freckling.

Huang et al. and other prior efforts to reduce freckling and other solidification-related defects have been limited to castings that do not exceed lengths of forty inches (about one hundred centimeters), due in large part to size and weight limitations imposed by mold strength, furnace size, etc. Freckling and size/weight complications associated with directional solidification have essentially prevented the production and use of single-crystal and directionally-solidified castings of sufficient size for certain applications, including the last-stage buckets of land-based gas turbines. An example is the last-stage buckets of the H and FB class gas turbines used in the power-generating industry and manufactured by the assignee of the present invention. The lengths (about 30 inches (about 75 cm) or more), cross-sections and weights of these buckets have rendered them very difficult to produce as SX and DS castings, particularly with respect to achieving microstructures that can be heat treated to obtain desired mechanical properties. Consequently, last-stage buckets of the H and FB class gas turbines have been limited to being produced as equiaxed castings. However, the ability to produce these buckets as defect-free SX and DS castings would achieve significantly improved mechanical properties, such as creep and low-cycle fatigue (LCF), and would therefore be of great benefit to the overall performance and efficiency of a large gas turbine.

### BRIEF DESCRIPTION OF THE INVENTION

The present invention provides a process capable of producing metallic castings having unidirectional crystal structures and lengths of one hundred centimeters or more, yet are substantially free of freckle defects. The present invention also provides metallic castings with unidirectional crystal structures that are formed by such a process.

According to a first aspect of the invention, the process includes pouring a molten metal alloy into a cavity of a preheated mold within a heating zone, withdrawing the mold from the heated zone through a heat shield and into a cooling zone to directionally solidify the molten metal alloy, and then cooling the mold to produce the casting and the unidirectional crystal structure thereof that is substantially free of freckle defects having a size greater than one hundred centimeters. According to preferred aspects of the invention, the heat shield operates as a barrier to thermal radiation between the heated zone and the cooling zone, and the mold is withdrawn at a rate that, in combination with the heat shield, maintains a thermal gradient of at least 35°C/cm, for example, 50°C/cm or more, to solidify the molten metal alloy and form primary dendrite arms having an average spacing therebetween of about 150 micrometers to about 500 micrometers. A high cooling rate of at least about 20°C/minute also appears to be a factor in achieving the desired primary dendrite arm spacing.

The unidirectional crystal structure of the casting can be a columnar single crystal microstructure (SX) with a preferred single crystal direction of <001>, though crystalline structures having orientations other than <001> are also within the scope of the invention, as are columnar polycrystalline microstructures (DS). Castings that can be produced in accordance with the invention are well suited for components of a gas turbine, such as buckets, nozzles, and other components of gas turbines, and may be formed of nickel-base alloys and intermetallics, for example, a nickel aluminide (NiAl) intermetallic.

A significant advantage of this invention is that castings produced by the process of this invention can far exceed in length, cross-section, and/or weight what was possible with prior casting techniques. In particular, heat-treatable, freckle-free last stage buckets of land-based gas turbines can be produced to have single-crystal and directionally-solidified microstructures by this process, whereas last-stage buckets and other castings with lengths exceeding one hundred centimeters (and correspondingly large cross-sections and weights) were previously not possible. As such, the reduction of the incidence of freckling is greater than was expected for very large SX and DS castings, and the result is the absence of freckling that would be otherwise expected in SX and DS castings of these lengths, cross-sections and weights if produced under conventional processing conditions.

Other objects and advantages of this invention will be better appreciated from the following detailed description.

### BRIEF DESCRIPTION OF THE DRAWINGS

FIG. 1 is representative of a turbine bucket that can be formed as a single-crystal casting in accordance with an embodiment of the present invention.
FIGS. 2 and 3 represent cross-sectional views showing two steps of a casting operation to produce a large single-crystal turbine blade in accordance with an embodiment of this invention.
FIG. 4 is a plot of primary dendrite arm spacing versus casting length for castings produced in accordance with U.S. Patent No. 6,217,286.
FIG. 5 is a plot of primary dendrite arm spacing versus casting length for castings produced in accordance with embodiments of the present invention.

### DETAILED DESCRIPTION OF THE INVENTION

The present invention provides for the capability of producing unidirectionally-solidified castings beyond the capabilities and expectations of prior directional casting technologies. The invention builds upon a discovery disclosed in commonly-assigned U.S. Patent No. 6,217,286 that certain solidification process conditions, as evidenced by dendrite arm spacing, are capable of preventing freckles in castings of up to forty inches (about one hundred centimeters) in length. The capability provided by the present invention was unexpected from US6,217,286, as evident from the teachings of this patent. Particularly unexpected was the ability to achieve and maintain a sufficient thermal gradient capable of forming primary dendrite arms with an acceptable arm spacing that would result in the prevention of freckling. Because the thermal gradient is dependent on the cooling rate and solidification rate (approximately equal to the withdrawal rate) of the casting process (a simplified statement of this relationship is that thermal gradient is approximately equal to the cooling rate divided by the withdrawal rate), the invention requires close control over the cooling rate and withdrawal rate of the casting process.

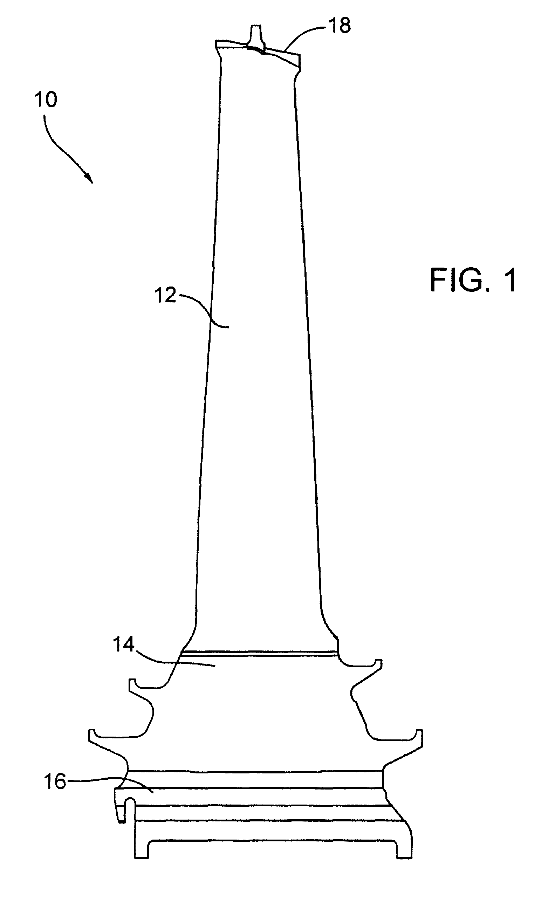

The present invention reduces the tendency for freckling while achieving mechanical properties for which SX and DS castings are desired, particularly high temperature strength (including creep resistance) and fatigue properties for use in such applications as buckets (blades), nozzles (vanes), and other large components in the hot gas flow path of a gas turbine. Of particular interest are the very large castings required for last-stage turbine buckets used in land-based gas turbines, whose lengths (exceeding one hundred centimeters), cross-sections, and/or weights have prevented their manufacture as SX and DS castings. As an example, FIG. 1 represents a third-stage bucket 10 for a land-based gas turbine, such as gas turbines used in the power-generating industry. The bucket 10 has an airfoil 12 and shank 14, with a dovetail 16 formed on the shank 14 for anchoring the bucket 10 to a turbine disk (not shown). Depending on the particular application, the length of the bucket 10, from tip shroud 18 to dovetail 16, may be about 30 inches (about 75 cm) or more, including lengths of about 50 inches (about 125 cm) or more. Furthermore, the weight (mass) of the bucket 10 often exceeds 40 pounds (about 18 kg) and may exceed 50 pounds (about 23 kg), with weights (mass) of even 100 pounds (about 45 kg) or more also being possible. While the following discussion will focus on gas turbine buckets, the invention also applies to a variety of other components, including components within the combustion section of a gas turbine.

Buckets of the type represented in FIG. 1 are conventionally produced as equiaxed castings of precipitation-hardened nickel-base superalloys, such as IN738, René 77, or Udimet® 500. As is in the case of first and second-stage turbine buckets, the performance of the bucket 10 could be significantly improved if it could be unidirectionally cast to have a columnar single crystal (SX) or columnar polycrystalline (DS) microstructure. The advantages of this invention will be described with reference to the bucket 10 of FIG. 1, though the teachings of this invention are generally applicable to other large components that could benefit from being unidirectionally cast.

The bucket 10 would also benefit from being cast from more advanced high-temperature materials. Of particular interest are superalloys specifically formulated for casting as SX and DS castings, and intermetallics such as nickel aluminide (NiAl) intermetallic materials. Particular nonlimiting examples of superalloys that could be used include René N5 (nominal composition, by weight, about 7.5% Co, 7.0% Cr, 6.5% Ta, 6.2% Al, 5.0% W, 3.0% Re, 1.5% Mo, 0.15% Hf, 0.05% C, 0.004% B, 0.01% Y, the balance nickel), René N4 (nominal composition, by weight, about 9.75% Cr, 7.5% Co, 4.2% Al, 3.5% Ti, 1.5% Mo, 6.0% W, 4.8% Ta, 0.5% Nb, 0.15% Hf, 0.05% C, 0.004% B, the balance nickel), GTD111 (nominal composition, by weight, about 14.0% Cr, 9.5% Co, 3.0% Al, 4.9% Ti, 1.5% Mo, 3.8% W, 2.8% Ta, 0.010% C, the balance nickel), and GTD444 (nominal composition, by weight, about 9.75% Cr, 7.5 Co, 3.5% Ti, 4.2% Al, 6% W, 1.5% Mo, 4.8% Ta, 0.08% C,0.009% Zr, 0.009% B, the balance nickel).

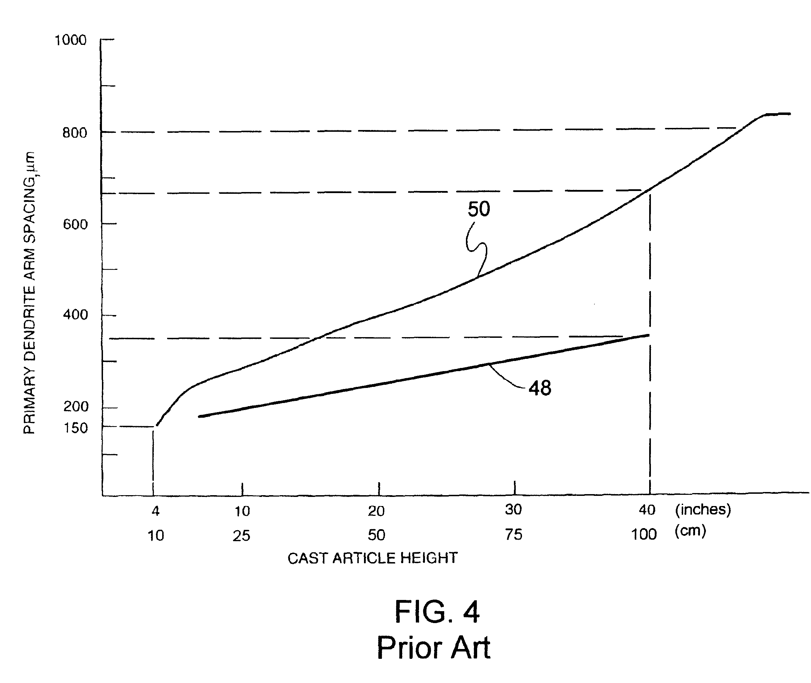

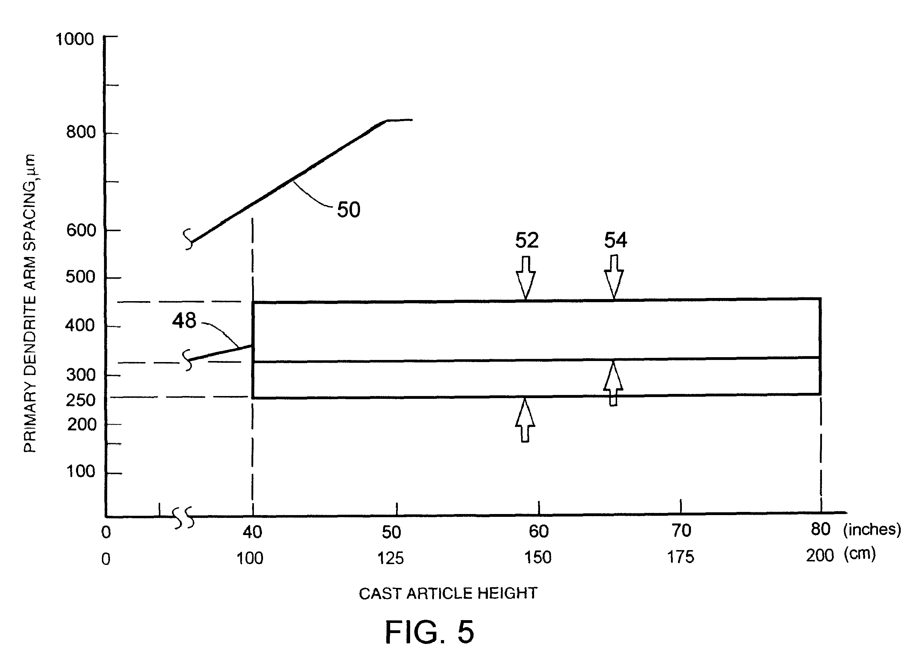

As known in the art, freckles form in part as a result of molten metal convection in the casting mold which disrupts the unidirectional solidification process, producing irregularities seen on SX and DS casting surfaces as little chains of equiaxed crystals. Furthermore, freckles can act as grain initiators during the solidification process that cause unacceptable off-axial grains, and may reduce fatigue life of the casting. According to one aspect of the invention, external and internal freckling can be inhibited and even eliminated in SX and DS castings exceeding one hundred centimeters in length (with correspondingly large cross-sections and weights) by achieving greater control of the primary dendrite arm spacing at these casting lengths, more particularly achieving finer dendrite arm spacing at these casting sizes to reduce buoyancy impact, which in turn can be attained by improving the thermal separation between the heating and cooling zones of a unidirectional casting process to achieve an even greater thermal gradient (for example, 80°C/cm and higher) at the solidification front of the casting. In particular, US6,217,286 utilized a thermal gradient of up to about 80°C/cm to obtain primary dendrite arm spacings of about 150 micrometers to less than 800 micrometers, preferably about 150 micrometers to about 650 micrometers, and more preferably about 150 micrometers to about 350 micrometers for castings of up to one hundred centimeters. These spacings roughly correspond to arm spacing-casting length ratios of up to about 8.0 micrometers/centimeter for a 100-cm casting. In comparison, the present invention achieves freckle-free SX castings by narrowly limiting the primary dendrite arm spacing to a range of about 150 micrometers to about 500 micrometers, more preferably about 250 to about 450 micrometers, and most preferably about 325 to 450 micrometers (about 13 to about 18 mils) for castings exceeding one hundred centimeters, corresponding to a maximum arm spacing-casting length ratio of not more than 5 micrometers/centimeter and preferably not more than 4.5 micrometers/centimeter for a 100-cm casting. For comparison, FIG. 4 plots the preferred and most preferred ranges from the US6,217,286 patent as lines 50 and 48, respectively, over casting lengths of four to forty inches (about ten to about one hundred centimeters), while FIG. 5 plots the ranges 52 and 54 for, respectively, the preferred and most preferred primary dendrite arm spacings of this invention for castings with lengths that exceed forty inches (one hundred centimeters) For the sake of comparison, the line 50 for the preferred range of US6,217,286 is plotted beyond casting lengths of forty inches, though there was no expectation or suggestion in US6,217,286 that castings longer than forty inches could be cast under these conditions without producing unacceptably high levels of freckles. Furthermore, ceramic molds available to Huang et al. limited the size of castings that could have been considered by Huang et al.

In view of the above, an important aspect and unexpected result of the present invention is that large castings with lengths exceeding one hundred centimeters (with correspondingly large cross-sections and weights) can be manufactured having a fine dendrite arm spacing of not more than 500 micrometers, for example, about 150 to about 500 micrometers, to avoid freckling. More particularly, the primary dendrite arm spacing is most preferably between 325 and 450 micrometers. The targeted spacing may be correlated to the length of the casting, corresponding to a spacing/length ratio of about 0.75 to about 5.0, or more narrowly about 1.625 to about 4.5 micrometers per centimeter, and more preferably about 2.25 to about 3.25 micrometers per centimeter. Other potential casting defects may also be minimized with this invention, including high angle boundaries that tend to form at protruded sections of castings, and grains that form streaks (slivers) in the microstructure.

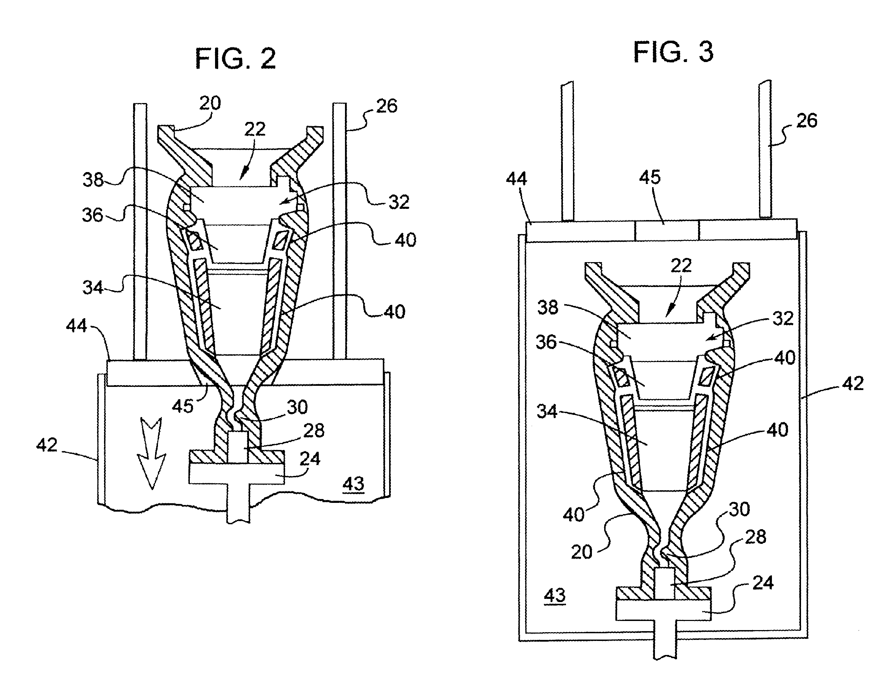

FIGS. 2 and 3 represent a shell mold 20 of a type suitable for producing a single-crystal casting of this invention. As known in the art, the mold 20 is preferably formed of a material such as alumina or silica, and has an internal cavity 22 corresponding to the desired shape of a casting 32, represented as a turbine bucket. As such, the cavity 22 is configured to produce the casting 32 with an airfoil portion 34, shank 36, and dovetail 38, and may contain cores (not shown) for the purpose of forming cooling passages within the casting 32. The mold 20 is shown secured to a chill plate 24 and placed in a heating zone 26 (for example, a Bridgman furnace) to heat the mold 20 to a temperature equal to or above the melting temperature of the alloy, and more particularly above the liquidus temperature of the alloy. A cooling zone 42 is represented as being located directly beneath the heating zone 26, and a baffle or heat shield 44 is represented as being between and separating the heating and cooling zones 26 and 42. The cooling zone 42 may be a tank containing a liquid cooling bath 43, such as a molten metal, or a radiation cooling tank that may be evacuated or contain a gas at ambient or cooled temperature. The cooling zone 42 may also employ gas impingement cooling (for example, see U.S. Patent No. 7,017,646 to Balliel et al.) or a fluidized bed (for example, see U.S. Patent No. 6,443,213). Particularly suitable liquids for the cooling bath 43 include molten tin at a temperature of about 235 to about 350°C and molten aluminum at a temperature of up to about 700°C, with molten tin believed to be especially suitable because of its low melting temperature and low vapor pressure.

The heat shield 44 is situated to be in close contact with the lower end of the heating zone 26 and the cooling zone 42, and in the case of a cooling bath 43 may float on its surface. The purpose of the heat shield 44 is to insulate the cooling zone 42 from the heating zone 26, and particularly form a barrier to thermal radiation emitted by the heating zone 26, thereby promoting a steep thermal gradient between the mold 20 and the cooling bath 43. The heat shield 44 may be a single layer or multiple layers of rigid and/or flexible thermal barrier materials, such as flowing graphite raft, a refractory felt material, or a high melting point metal. The heat shield 44 is configured to have a variable-sized opening 45 that, as represented in FIG. 2, enables the heat shield 44 to fit closely around the shape of the mold 20 as it is withdrawn from the heating zone 26, through the heat shield 44, and into the liquid cooling bath 43.

The casting process is preferably carried out in a vacuum or an inert atmosphere, with the mold 20 preheated to a temperature above the alloy's liquidus temperature, as a nonlimiting example, about 1370°C to about 1600°C. The molten alloy is poured into the preheated mold 20, after which unidirectional solidification is initiated by withdrawing the base of the mold 20 and chill plate 24 downwardly at a fixed withdrawal rate into the cooling zone 42, until the mold 20 is entirely within the cooling zone 42 as represented in FIG. 3. The temperature of the chill plate 24 is preferably maintained at or near the temperature of the cooling zone 44, such that dendritic growth begins at the lower end of the mold 20 and the solidification front travels upward through the mold 20. The casting 32 grows epitaxially (for example, with the <100> orientation) based on the crystalline structure and orientation of a small block of single-crystal seed material 28 at the base of the mold 20, from which a single crystal forms from a crystal selector 30, for example, a pigtail sorting structure. The columnar single crystal becomes larger in the enlarged section of the cavity 22. A bridge 40 connects protruding sections of the casting 32 with lower sections of the casting 32 so that a unidirectional columnar single crystal forms substantially throughout the casting 32. The casting 32 is deemed to be a substantially columnar single crystal if it does not have high angle grain boundaries, for example, greater than about twenty degrees.

Uniform primary dendrite arm spacings are achieved by the strong unidirectional thermal gradients imposed on the casting 32 as a result of the heat shield 44 and the cooling zone 42. According to a preferred aspect of the invention, the thermal gradient at the solidification front of the casting 32 is greater than 35°C/cm, preferably greater than 50°C/cm, and more preferably greater than 80°C/cm. Thermal gradients of less than 50°C/cm and particularly less than 30°C/cm are believed to be unacceptable for attaining the primary dendrite arm spacing in large castings of primary interest to this invention. Based on their mathematical relationship, the high thermal gradients of this invention also require high cooling rates relative to the withdrawal rate used, the latter of which can be up to at least twenty inches/hour (about 8.5 mm/minute).

Those skilled in the art will appreciate that a DS casting can be produced in a similar manner, though with modifications to the mold 20, such a growth zone at the base of the mold 20 that is open to the chill plate 24, and omission of the seed material 28 and/or crystal selector 30.

In experiments leading to the present invention, last-stage buckets similar to the representation of FIG. 1 were cast. The castings were about 30 to about 50 inches (about 750 to about 1250 millimeters) in length. The compositions of the buckets were the nickel-based superalloys René N4 and GTD444, both of which are specifically formulated for SX and DS castings. Single-crystal castings were then prepared in accordance with commercial practices for the alloys, generally in accordance with the casting process described above. The casting molds were about ten inches (about 25 cm) longer than their respective castings, and filled to contain up to about 400 lbs. (about 180 kg) of molten alloy. The casting furnace temperature was about 2750°F (about 1510°C). Cooling was by a liquid bath of molten tin maintained at a temperature of about 240°C, and the thermal gradient in the castings during cooling was about 85°C/cm. A conventional withdrawal rate of about three inches/hour (about 1.25 mm/minute) was used to produce a casting as a baseline comparison, while other castings were produced using higher experimental rates of about six to twelve inches/hour (about 2.5 to about 5 mm/minute). Based on these values, the cooling rates were about 10°C/minute when using the conventional withdrawal rate (three inches/hour), and about 20 to about 40°C/minute using the higher withdrawal rates (six and twelve inches/hour).

Following the casting operation, primary dendrite arm spacings in the castings were measured by metallography, and evidence of freckling was examined by macro-etching the casting surfaces, followed by metallographic examination. From the examinations, it was observed that the grain structure broke down in those casting produced at the conventional withdrawal rate (corresponding to a cooling rate of about 10°C/minute). Furthermore, the casting had many freckles at its thicker sections and at sections where the cross-section changed, such as the tip shroud. Dendrite spacing was about 25 to about 30 mils (about 635 to about 760 micrometers), which is within the broad range accepted in Huang et al. Nonetheless, the casting was unable to be heat treated due to excessive segregation in its microstructure, resulting in incipient melting.

In contrast, the experimental castings produced at the higher withdrawal rates (corresponding to cooling rates of about 20 to about 40°C/minute) did not contain any freckles. Furthermore, the grains were straight, evidencing that grain growth was not influenced by other heat extraction directions. Dendrite spacing was about 16 to about 21 mils (about 400 to about 530 micrometers), corresponding to a minimum dendrite spacing to casting length ratio of about 0.32 µm/cm. Finally, and significantly, their microstructures allowed the castings to be heat treated to obtain desired mechanical properties for the buckets.

Based on these results, it was concluded that SX and DS castings formed of superalloys formulated for SX and DS and cast to sizes produced in the experiment (lengths of about 760 mm (about 30 inches) and longer, weights exceeding 40 pounds (about 18 kg), and correspondingly large cross-sections benefit from relatively high thermal gradients (preferably greater than 80°C/cm and more preferably about 85°C/cm or more). The benefit of high thermal gradients appears to also depend on the use of relatively high cooling rates (greater than 10°C/minute, such as about 20°C/minute or more) relative to withdrawal rate. The process may also employ relatively high withdrawal rates, for example, greater than 1.25 mm/minute, such as about 2.5 to about 5 mm/minute, though lower and higher withdrawal rates are also within the scope of this invention.

While the invention has been described in terms of specific embodiments, it is apparent that other forms could be adopted by one skilled in the art. For example, the physical configuration of the castings could differ from that shown, and materials and processes other than those noted could be used.

## Claims

1. A process of producing a metallic casting having a length greater than one hundred centimeters and a unidirectional crystal structure that is substantially free of freckle defects, the process comprising:
pouring a molten metal alloy into a cavity in a preheated mold located within a heating zone, the cavity having the shape of the casting;
withdrawing the mold from the heating zone, through a heat shield, and into a cooling zone to directionally solidify the molten metal alloy, the heat shield operating as a barrier to thermal radiation between the heating zone and the cooling zone, the mold being withdrawn at a rate that, in combination with the heat shield, maintains a thermal gradient of greater than 50°C/cm in the molten metal alloy to solidify the molten metal alloy and form primary dendrite arms having an average spacing therebetween of about 150 micrometers to about 500 micrometers; and then
cooling the mold to produce the casting and the unidirectional crystal structure thereof that is substantially free of freckle defects having a size greater than one hundred centimeters.

2. The process according to claim 1, wherein the casting has a mass of at least about 18 kg.

3. The process according to claim 1 or claim 2, wherein the thermal gradient is greater than 80°C/cm.

4. The process according to any preceding claim, wherein the withdrawal rate is greater than 1.25 mm/minute.

5. The process according to any preceding claim, wherein in combination the thermal gradient and the withdrawal rate result in a cooling rate of at least 20°C/minute.

6. The process according to any preceding claim, wherein the average spacing between the primary dendrite arms is about 325 micrometers up to about 450 micrometers.

7. The process according to any preceding claim, wherein the casting is **characterized by** a ratio of the average spacing of the primary dendrite arms to the length of the casting of about 0.75 to about 5.0 micrometers per centimeter.

8. The process according to any preceding claim, wherein the unidirectional crystal structure has a columnar single crystal microstructure, or a columnar polycrystalline microstructure.

9. The process according to any preceding claim, wherein the metal alloy is chosen from the group consisting of nickel-base superalloys and intermetallic alloys.

10. The process according to any preceding claim, wherein the casting is a component for a gas turbine.

11. The process according to claim 10, wherein the component is a last-stage bucket of a land-based gas turbine.

12. The casting produced according to the process of any preceding claim.
